# EUROPEAN PATENT APPLICATION

(11) **EP 1 947 205 A2**
(43) Date of publication of application: **23.07.2008**
(21) Application number: 08150427.6
(22) Date of filing: 18.01.2008
(51) Int. Cl.: C22C 30/00, B22D 7/00, C22C 1/02, C23C 14/34

(54) **Low oxygen content, crack-free heusler and heusler-like alloys & deposition sources & methods of making same**

(30) Priority: 19.01.2007 US 881440 P; 17.01.2008 US 15666
(71) Applicant: Heraeus, Inc., Chandler AZ 85226 (US)
(72) Inventor: Ziani, Abdelouahab, Chandler, AZ 85226 (US)
(74) Representative: Driver, Virginia Rozanne

(57) **Abstract**

A method of forming Heusler or Heusler-like alloys of formula X₂YZ or XYZ comprises providing a crucible comprised of at least one metal oxide material thermodynamically stable to molten transition metals; supplying predetermined amounts of constituent elements or master alloy materials of the alloy to the crucible; and melting the constituent elements or master alloy materials under vacuum or a partial pressure of an inert gas to form alloys containing less than about 50 ppm oxygen. Crack-free alloys are formed by casting the alloys in a mold utilizing a multi-stage stress-relieving, heat-assisted casting process. Also disclosed are crack-free Heusler and Heusler-like alloys of formula X₂YZ or XYZ containing less than about 50 ppm oxygen and deposition sources, e.g., sputtering targets, fabricated therefrom.

## Description

### CROSS-REFERENCE TO PROVISIONAL APPLICATION

This application claims priority from U.S. provisional patent application Serial No. 60/881,440 filed January 19, 2007, the entire disclosure of which is incorporated herein by reference.

### FIELD OF THE DISCLOSURE

The present disclosure relates generally to improved, low oxygen content, crack-free Heusler and Heusler-like alloys and deposition sources and to novel melting and casting processes for making same. The disclosure enjoys particular utility in the fabrication of high quality deposition sources, e.g., sputtering targets, utilized in the manufacture of devices comprising thin film layers of Heusler and/or Heusler-like alloys, e.g., electronic spin-based magnetic heads/devices, magneto-resistance tunnel (TMR) junction devices, giant magneto-resistance (GMR) spin heads/sensor devices, etc.

### BACKGROUND OF THE DISCLOSURE

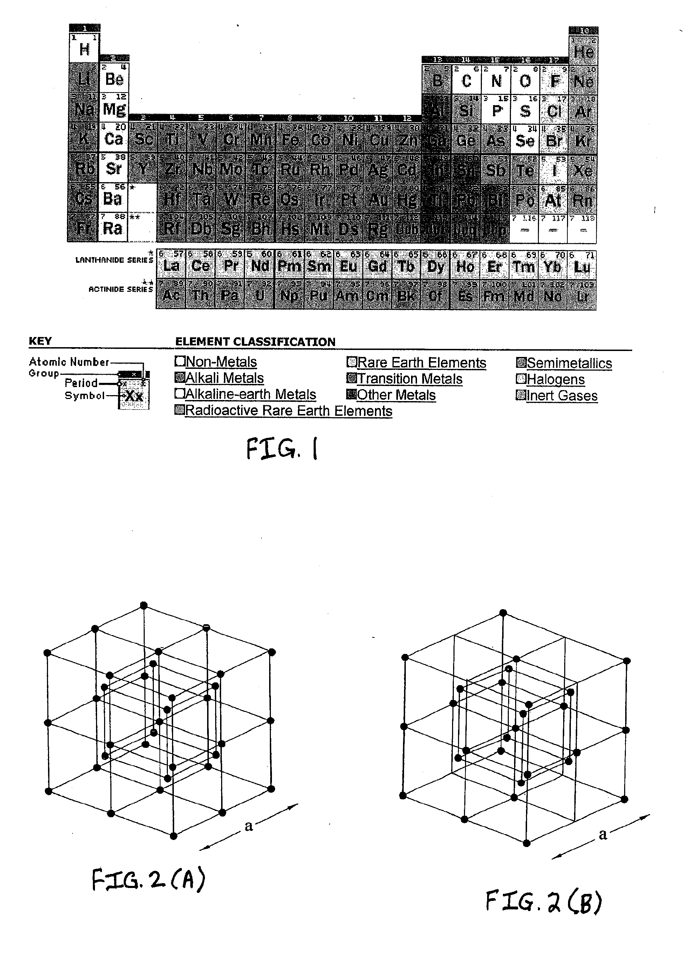

For all purposes of this disclosure, Heusler alloys and Heusler-like alloys are considered as intermetallic alloys with compositions of general formula XYZ or X₂YZ, where X and Y each are at least one transition group element (i.e., a metal element wherein the d-band of electrons contains less than the maximum of 10 electrons) and Z is at least one element in Groups 13 - 16 of the Periodic Table of the Elements shown in FIG. 1, and thus may include one or more semiconductive elements such as Si and Ge. Heusler alloys of X₂YZ formula exhibit cubic L2₁ crystal structure (a unit cell of this type structure is shown in FIG. 2 (A)) and are termed "full" Heusler alloys; whereas Heusler alloys of XYZ formula exhibit C1_{b} crystal structure (a unit cell of this type structure is shown in FIG. 2 (B)) and are termed "half" Heusler alloys.

Many Heusler alloys contain Mn and are ferromagnetic, the ferromagnetism being critically dependent upon both the magnetic and chemical ordering of the Mn atom. In addition, Mn-containing Heusler alloys exhibit very high Curie temperatures (e.g., ~ 700 °C) and large magnetic moments (e.g., 3.5 µ*_{β}*/formula unit). Further, Mn-containing ferromagnetic Heusler alloys can exhibit a spin polarization value exactly equal to one, in which case the alloy is termed "half-metallic" ferromagnetic since electrons populate only one spin band and be 100 % spin polarized. As a consequence, one spin band has metallic character while the other spin band has semiconductive character. The latter characteristic makes such alloys particularly desirable for fabricating GMR heads utilized in high areal recording density magnetic media and other applications. However, it should be recognized that, as utilized herein, the expression "Heusler-like" alloys refers to alloys which are not necessarily magnetic but have the crystal structure of a Heusler alloy without the presence of Mn.

Generally speaking, the chemical compositions of Heusler alloys and Heusler-like alloys are such that brittle intermetallic phases are formed in ingots produced by conventional casting methodologies. The presence of the brittle phases results in ingot cracking upon post-casting cool-down. Attempts to overcome this problem, as by development of alternative processes involving powder metallurgical techniques, have been unsuccessful due to incorporation of excessive, unacceptable amounts of oxygen in the final products. For example, a number of the intended applications for Heusler alloys, including electronic spin-based magnetic heads/devices, magneto-resistance tunnel (TMR) junction devices, and giant magneto-resistance (GMR) spin heads/sensor devices, require oxygen levels in the sub-50 ppm range.

Accordingly, there exists a clear need for the development of a wide variety of improved, low oxygen content, crack-free Heusler and Heusler-like alloys and methodology therefore, which methodology can be practiced in cost-effective manner for producing materials suitable for use as deposition sources in high technology processing, e.g., deposition of thin films via sputtering techniques.

### SUMMARY OF THE DISCLOSURE

An advantage of the present disclosure is improved methodology for forming Heusler and Heusler-like alloys containing very low amounts of oxygen, i.e., less than about 50 ppm.

Another advantage of the present disclosure is improved methodology for forming crack-free Heusler and Heusler-like alloys.

Yet another advantage of the present disclosure is improved methodology for forming crack-free Heusler and Heusler-like alloys containing very low amounts of oxygen, i.e., less than about 50 ppm.

A further advantage of the present disclosure is improved, crack-free Heusler and Heusler-like alloys.

A still further advantage of the present disclosure is improved Heusler and Heusler-like alloys containing very low amounts of oxygen, i.e., less than about 50 ppm.

Another advantage of the present disclosure is improved, crack-free Heusler and Heusler-like alloys containing very low amounts of oxygen, i.e., less than about 50 ppm.

Further advantages of the present disclosure are improved deposition sources, e.g., sputtering targets, comprising crack-free Heusler and Heusler-like alloys containing very low amounts of oxygen, i.e., less than about 50 ppm.

Additional advantages and other features of the present disclosure will be set forth in the description which follows and in part will become apparent to those having ordinary skill in the art upon examination of the following or may be learned from the practice of the present disclosure. the advantages of the present disclosure may be realized and obtained as particularly pointed out in the appended claims.

According to one aspect of the present disclosure, the foregoing and other advantages are obtained in part by an improved method of forming a Heusler or Heusler-like alloy of formula X₂YZ or XYZ, comprising steps of:
(a) providing a crucible comprised of at least one metal oxide material thermodynamically stable to molten transition metals;
(b) supplying predetermined amounts of constituent elements or master alloy materials of the Heusler or Heusler-like alloy to the crucible; and
(c) melting the constituent elements or master alloy materials under vacuum or a partial pressure of an inert gas to form a Heusler or Heusler-like alloy containing less than about 50 ppm oxygen.

Preferably, step (a) comprises providing a crucible comprised of at least one metal oxide material selected from the group consisting of: Y₂O₃, CaO, ThO₂, MgO, ZrO₂, and Al₂O₃.

According to certain embodiments of the present disclosure, step (b) comprises supplying predetermined amounts of different constituent transition metal elements X and Y, each selected from the group consisting of Sc, Ti, V, Cr, Mn, Fe, Co, Ni, Y, Zr, Nb, Mo, Ru, Rh, Lu, Hf, Ta, W, Re, Ir, and Pt; and supplying predetermined amounts of at least one constituent element Z, selected from the group consisting of: Al, Si, Ga, Ge, As, In, Sn, Sb, Te, Tl, Pb, and Bi; whereas, according to other embodiments of the present disclosure, step (b) comprises supplying a predetermined amount of a first master alloy of formula XY, comprising different transition metal elements X and Y each selected from the group consisting of Sc, Ti, V, Cr, Mn, Fe, Co, Ni, Y, Zr, Nb, Mo, Ru, Rh, Lu, Hf, Ta, W, Re, Ir, and Pt; and a predetermined amount of a second master alloy of formula XZ, comprising a transition metal element X selected from the group consisting of Sc, Ti, V, Cr, Mn, Fe, Co, Ni, Y, Zr, Nb, Mo, Ru, Rh, Lu, Hf, Ta, W, Re, Ir, and Pt and an element Z selected from the group consisting of: Al, Si, Ga, Ge, As, In, Sn, Sb, Te, Tl, Pb, and Bi.

Preferably, step (b) further comprises supplying at least one deoxidizer material to the crucible, selected from the group consisting of: Y, Ca, and Mg.

According to preferred embodiments of the present disclosure, the method further comprises a step of:
(d) melting and casting the Heusler or Heusler-like alloy formed in step (c) in a mold to form an as-cast ingot and subjecting the as-cast ingot to a stress-relieving, heat-assisted casting process to form a crack-free ingot.

Preferably, step (d) comprises subjecting the as-cast ingot to a multi-stage post-casting thermal profile to form the crack-free ingot, the multi-stage thermal profile comprising: (1) a mold pre-heat first stage during which the temperature of the casting mold is increased to and maintained at a predetermined elevated temperature; (2) a casting and cool-down second stage initiated upon pouring of the molten Heusler or Heusler-like alloy material into the pre-heated mold to form the as-cast ingot; (3) a mold and ingot temperature hold during stress relief third stage for performing continuous stress relief at temperatures where Heusler and Heusler-like alloy materials are most susceptible to crack initiation; and (4) a final controlled cool-down fourth stage during which a slow cool-down rate is imposed on the ingot in order to prevent build-up of thermal gradients and subsequent crack development.

Another aspect of the present disclosure is an improved method comprising steps of:
(a) providing a molten Heusler or Heusler-like alloy of formula X₂YZ or XYZ; and
(b) casting the molten Heusler or Heusler-like alloy in a mold utilizing a stress-relieving, heat-assisted casting process to form a crack-free, cast ingot.

Preferably, step (a) comprises providing a molten Heusler or Heusler-like alloy containing less than about 50 ppm oxygen; X and Y are different transition metal elements each selected from the group consisting of Sc, Ti, V, Cr, Mn, Fe, Co, Ni, Y, Zr, Nb, Mo, Ru, Rh, Lu, Hf, Ta, W, Re, Ir, and Pt; and Z is at least one element selected from the group consisting of: Al, Si, Ga, Ge, As, In, Sn, Sb, Te, Tl, Pb, and Bi.

According to embodiments of the present disclosure, the method further comprises a step of:
(c) forming a deposition source from the crack-free, cast ingot, e.g., a sputtering target including a backing plate.

Preferably, step (b) comprises performing: (1) a mold pre-heat first stage during which the temperature of the casting mold is increased to and maintained at a predetermined elevated temperature; (2) a casting and cool-down second stage initiated upon pouring of the molten Heusler or Heusler-like alloy material into the pre-heated mold to form an as-cast ingot; (3) a mold and ingot temperature hold during stress relief third stage for performing continuous stress relief at temperatures where Heusler alloy materials are most susceptible to crack initiation; and (4) a final controlled cool-down fourth stage during which a slow cool-down rate is imposed on the ingot in order to prevent build-up of thermal gradients and subsequent crack development.

Yet another aspect of the present disclosure is improved, crack-free Heusler or Heusler-like alloys of X₂YZ or XYZ formula containing less than about 50 ppm oxygen.

According to embodiments of the present disclosure, X and Y each are different transition metal elements selected from the group consisting of Sc, Ti, V, Cr, Mn, Fe, Co, Ni, Y, Zr, Nb, Mo, Ru, Rh, Lu, Hf, Ta, W, Re, Ir, and Pt; and Z is at least one element selected from the group consisting of: Al, Si, Ga, Ge, As, In, Sn, Sb, Te, Tl, Pb, and Bi.

Embodiments of the present disclosure include those of X₂YZ formula, wherein X is Co, Y is Mn, and Z is Al, Si, or Ge.

Still another aspect of the present disclosure is improved deposition sources comprising crack-free Heusler or Heusler-like alloys of X₂YZ or XYZ formula containing less than about 50 ppm oxygen, wherein X and Y each are different transition metal elements selected from the group consisting of Sc, Ti, V, Cr, Mn, Fe, Co, Ni, Y, Zr, Nb, Mo, Ru, Rh, Lu, Hf, Ta, W, Re, Ir, and Pt; and Z is at least one element selected from the group consisting of: Al, Si, Ga, Ge, As, In, Sn, Sb, Te, TI, Pb, and Bi.

Embodiments of the present disclosure include deposition sources of X₂YZ formula, wherein X is Co, Y is Mn, and Z is Al, Si, or Ge, and the deposition source is in the form of a sputtering target comprising a backing plate.

Additional advantages and aspects of the present disclosure will become readily apparent to those skilled in the art from the following detailed description, wherein embodiments of the present disclosure are shown and described, simply by way of illustration of the best mode contemplated for practicing the present disclosure. As will be described, the present disclosure is capable of other and different embodiments, and its several details susceptible of modification in various obvious respects, all without departing from the spirit of the present disclosure. Accordingly, the drawings and description are to be regarded as illustrative in nature, and not as limitative.

### BRIEF DESCRIPTION OF THE DRAWINGS

The following detailed description of the embodiments of the present disclosure can best be understood when read in conjunction with the following drawings, in which apparatus features are not necessarily drawn to scale but rather are drawn as to best illustrate the pertinent features, wherein:

FIG. 1 illustrates the Periodic Table of the Elements (as displayed at www.infoplease.com/periodictable.php);

FIG. 2 (A) shows the L2₁ crystal structure of a unit cell of a "full" Heusler or Heusler-like alloy of X₂YZ formula;

FIG. 2 (B) shows the C1_{b} crystal structure of a unit cell of a "half" Heusler or Heusler-like alloy of XYZ formula;

FIG. 3 shows an isothermal section of a ternary Co-Mn-Si alloy phase diagram;

FIG. 4 is a simplified, schematic representation of an example of a system for performing a casting process of Heusler and Heusler-like alloys including a stress relieving heat treatment according to the present disclosure;

FIG. 5 graphically shows an illustrative, but non-limitative, example of a thermal profile imposed on a Heusler or Heusler-like alloy casting during a stress-relieving, heat-assisted casting process according to the present disclosure;

FIG. 6 is an Ellingham diagram of highly stable metal oxide materials;

FIG. 7 is a SEM photomicrograph showing the as-cast microstructure of a CoMn_{0.25}Al_{0.25} Heusler alloy formed according to the present disclosure;

FIG. 8 is a SEM photomicrograph showing the as-cast microstructure of a CoMn_{0.25}Si_{0.25} Heusler alloy formed according to the present disclosure; and

FIG. 9 is a SEM photomicrograph showing the as-cast microstructure of a CoMn_{0.25}Ge_{0.25} Heusler alloy formed according to the present disclosure.

### DETAILED DESCRIPTION OF THE DISCLOSURE

The present disclosure is based upon the discovery that formation of improved, low oxygen content, crack-free cast Heusler and Heusler-like alloys (as utilized in the specification and appended claims, the expression "Heusler-like" alloys refers to alloys which are not necessarily magnetic but have the crystal structure of a Heusler alloy without the presence of Mn) and deposition sources comprising same, e.g., sputtering targets, suitable for use in the manufacture of a variety of thin film-based devices, including electronic spin-based magnetic heads/devices, magneto-resistance tunnel (TMR) junction devices, and giant magneto-resistance (GMR) spin heads/sensor devices, can be accomplished in efficient, cost-effective manner.

Briefly stated, according to one aspect of the present disclosure, efficient, cost-effective production of crack-free cast Heusler and Heusler-like alloys suitable, *inter alia,* for subsequent fabrication into deposition sources such as sputtering targets, is accomplished by a heat-assisted casting process comprising a multi-stage post-casting thermal profile specifically designed for relieving stress in the cast ingot. In addition, according to another aspect of the present disclosure, efficient, cost-effective production of Heusler and Heusler-like alloys with oxygen content reduced to very low levels, i.e., < ~ 50 ppm (as compared with a minimum 300 ppm oxygen content of Heusler and Heusler-like alloys prepared by currently available powder metallurgy processes), is accomplished by melting of the alloy components (feedstock) in a metal oxide-based crucible under vacuum or an inert gas atmosphere, e.g., Ar, the crucible material selected for thermodynamic stability vis-à-vis transition metals. Additional reduction of oxygen content is accomplished by addition of small amounts of suitable de-oxidizer materials to the melt charge in the crucible. The combination of melting and thermal stress-relief casting processes according to the present disclosure enables efficient, cost-effective production of high quality, low oxygen content, crack-free Heusler and Heusler-like cast alloy materials suitable for use in the manufacture of thin film-based advanced technology devices.

With reference to the Periodic Table of the Elements shown in FIG. 1, Heusler and Heusler-like alloys with compositions of general formula XYZ or X₂YZ may be formed according to the methodology of the present disclosure, wherein:
-- X and Y each are at least one transition group element in Groups 3-12, i.e., a metal element wherein the d-band of electrons contains less than the maximum of 10 electrons, selected from among Sc, Ti, V, Cr, Mn, Fe, Co, Ni, Y, Zr, Nb, Mo, Ru, Rh, Lu, Hf, Ta, W, Re, Ir, and Pt; and
-- Z is at least one element in Groups 13 - 16, selected from among Al, Si, Ga, Ge, As, In, Sn, Sb, Te, Tl, Pb, and Bi.

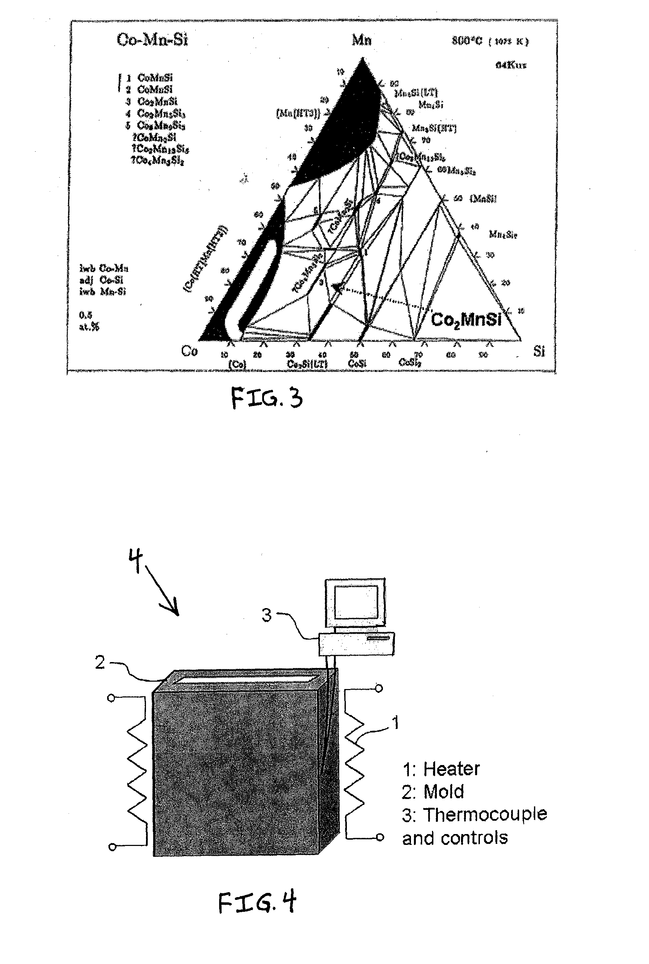

In more detail, Heusler and Heusler-like alloys are typically formed by melting and casting into ingots in a ceramic, graphite, or metal mold, the resultant alloy consisting of intermetallic phases. For example, and with reference to FIG. 3, which is an isothermal section of a ternary Co-Mn-Si alloy phase diagram, a Co-Mn-Si alloy, based on its phase equilibria, tends to form, in a full CoMn_{0.25}Si_{0.25} Heusler alloy of XYZ type, a Co₂MnSi phase with an L2₁ ordered crystal structure which forms an extremely brittle intermetallic phase. Post-casting residual stresses, combined with the brittle nature of the intermetallic phase, ultimately cause ingot cracking of this particular alloy composition. The residual stresses present in the alloy are internal stresses which do not depend upon external forces resulting from such factors as cold working, phase changes, or temperature gradients.

One effect of thermal cycling is induction of temperature gradients which in turn induce strains in the alloy material. The response of the material to thermal cycling directly depends on the mode of damage. For some materials, such as for example, intermetallics and ceramics, for which the prevailing stress accommodation mechanism is macro-cracking, one or more cracks suddenly propagate in the material as the ultimate strength of the material is reached. The lack of ductility at room and intermediate temperatures has been attributed to an inherently low cleavage stress, which is to some extent associated with a low mobile dislocation density, and the inability to activate a sufficient quantity of independent slip systems to satisfy the Von-Mises criterion for plastic deformation of polycrystalline aggregates. Internal strains due to ingot volumetric contraction developed during solidification, and those thermally induced strains arising upon cooling of a solidified ingot, must be controlled and minimized. Stated differently, in order to accommodate the thermal strains without incurring premature cracking, localized thermally activated dislocation climb processes must operate to maintain grain boundary compatibility. This can be achieved at an intermediate temperature during the cooling stage of the casting process via a stress-relieving treatment.

Stresses associated with solidification and thermally-induced strains are also considered as residual stresses. According to the present disclosure, stress relief treatment comprises heating the cast material to a suitable temperature, maintaining the material at that temperature for an interval sufficient to reduce the residual stresses, and then slowly cooling the material to minimize development of new residual stresses.

For some forgiving, albeit predominantly intermetallic alloy systems potentially susceptible to crack development while internal stresses are released during cool-down, stress relief heat treatment according to the present disclosure may be accomplished separately after the cast ingot is removed from the mold in an annealing furnace maintained at the designated stress-relieving temperature. For most Heusler and Heusler-like alloys contemplated herein, the extreme sensitivity of the materials to thermal gradients is such that a strictly controlled cool-down cycle must be applied immediately after casting and maintained until the ingot temperature falls below about 150 °C.

Stress relieving heat treatments according to the present disclosure may be accomplished by means of an external supplemental heat source maintained in contact with the casting mold. A schematic representation of an illustrative, but non-limitative, example of a system for performing stress relieving heat treatment according to the present disclosure is shown in FIG. 4, wherein system **4** comprises a casting mold **2** formed of a ceramic material or graphite surrounded (preferably on each side face) with a heating element **1,** e.g., a resistance heater, powered by an external source (not shown in the figure for illustrative simplicity) and controlled/regulated by means of a temperature sensor (e.g., thermocouple) + control unit **3** (e.g., a programmable electronic computer).

In practice, the mold and external heating elements are positioned within the chamber of the melting furnace and positioned for casting. In a first alternative arrangement utilizing a graphite casting mold **2,** the electrically conductive graphite mold is either resistively heated or inductively heated, and in a second alternative arrangement utilizing a ceramic casting mold **2,** the ceramic casting mold is either resistively heated or inductively heated via a susceptor material positioned between the mold and an induction coil.

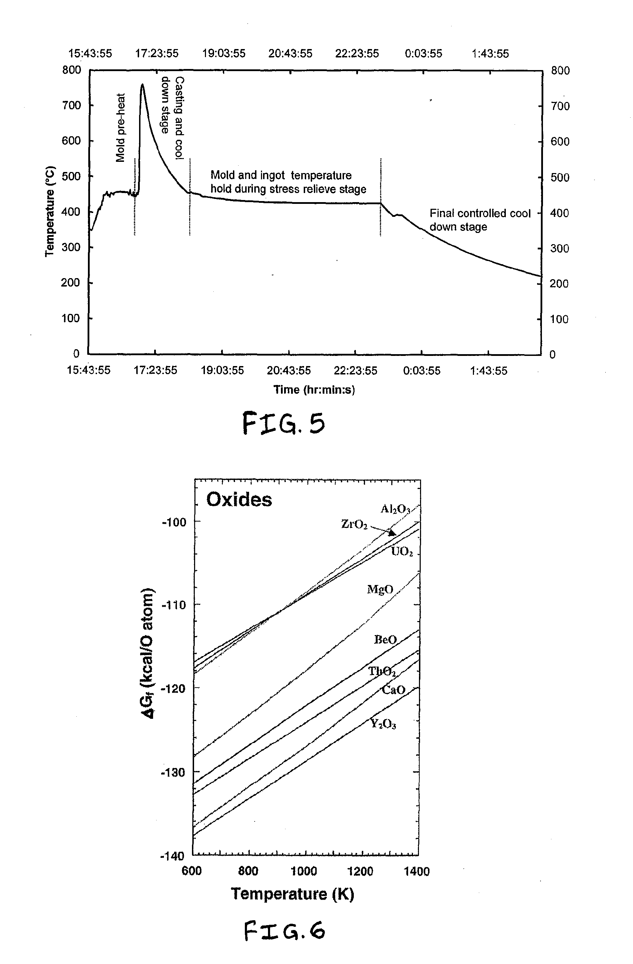

Referring to FIG. 5, graphically shown therein is an illustrative, but non-limitative, example of a thermal profile imposed on a Heusler or Heusler-like alloy casting during a stress-relieving, heat assisted casting process cycle according to the present disclosure, the thermal profile comprising four different stages, as follows:
-- first stage: the first stage, termed a "mold pre-heat" stage, is intended to raise the temperature of the casting mold to a predetermined elevated temperature, e.g., from about 400 to about 600 °C, illustratively 450 °C, and maintain that temperature for a short interval, e.g., 15 min., to allow for temperature settling;
-- second stage: the second stage, termed a "casting and cool-down stage", is initiated upon pouring of the molten Heusler alloy material into the pre-heated mold. During this stage, the mold temperature rapidly increases several hundred °C and then rapidly decreases. Heating of the mold at this stage proceeds via heat transfer from the higher temperature molten alloy. Consequently, the extent of the temperature increase is directly proportional to the mass amount of the molten alloy poured into the mold. By way of illustration only, as shown in FIG. 5, for a 13 kg Heusler alloy casting, the mold temperature, initially 450 °C, increased to 750 °C immediately after casting, followed by a rapid decrease;
-- third stage: the third stage, termed a "mold and ingot temperature hold during stress relief stage" is intended to perform continuous stress relief at critical intermediate temperatures, i.e., 400 - 600 °C, at which the Heusler alloy materials are most susceptible to crack initiation;
-- fourth stage: the fourth stage, termed a "final controlled cool-down stage" is aimed at imposing a slow cool-down rate on the cast ingot, typically at a rate of about 2 °C/min. or less, until a minimum temperature of about 150 °C is achieved, in order to prevent build-up of thermal gradients and subsequent crack development.

At this stage, a mechanically sound ingot is produced which is ready for further processing, e.g., cutting and grinding into deposition sources such as a sputtering targets. Given the brittle character of Heusler and Heusler-like alloys, cutting is preferably performed by electro-discharge machining (EDM) and final sizing to target dimensions (e.g., thickness) is accomplished by gentle grinding. Whereas manufacture of a monolithic Heusler or Heusler-like alloy target is possible, most targets are manufactured as an assembly comprising a target bonded to a metallic backing plate in order to maintain integrity and lifetime of the sputtering targets.

Reheating utilized for bonding of the target to the backing plate is critical in order to prevent crack development. Consequently, slow heating up to bonding temperature is performed prior to bonding. Generally, low melting point bonding materials, such as elastomeric adhesives, are utilized in order to enable bonding below 100 °C. Indium bonding can be successfully utilized under careful increase of the target-backing plate temperature to about 165°C.

Another aspect of the present disclosure is the development of improved melting and ingot casting methodology enabling formation of Heusler and Heusler-like alloys with very low oxygen (as well as other elements, e.g., sulfur) content, e.g., < ~ 50 ppm oxygen. As previously indicated, the use of powder metallurgy-based methodologies has been attempted for overcoming the limitations imposed by the extremely brittle nature of such alloys. However, the oxygen contents of the resultant powder metallurgy-derived alloys was significantly greater than that required for use in the above-described manufacturing applications. The high affinity of Heusler and Heusler-like alloys for oxygen is essentially due to the presence of the constituent transition metals which are known to strongly attract oxygen, especially when in powder form.

According to the present disclosure, melting is performed in metal oxide-based crucibles under a vacuum or at least a partial inert gas (e.g., Ar) atmosphere. The melt charge feedstock is comprised of pure metals, e.g., Co, electrolytic Mn flake, polycrystalline or single crystal Si or Ge, ingot byproduct pieces, and other solid forms. In some instances, master alloys such as Co-Ge and Co-Mn are preferred for better control of chemical composition. The master alloy compositions are chosen in order to depress the liquidus temperature via eutectic and other low temperature solid-to-liquid transitions. In the instant case, on the one hand, given the high rate of Ge and Mn evaporation during melting, Co-Ge and Co-Mn master alloys with predetermined compositions are used in order to enable melting at lower superheat temperatures, thereby minimizing evaporative losses and resulting in better composition control. On the other hand, e.g., when Co and Mn are melted together and consolidated into a master alloy, this practice provides a significantly "cleaner" master alloy feedstock for the subsequent Heusler alloy melting stage. In this regard, Mn flake was observed to generate a substantial amount of slag upon melting. Consequently, a first melting stage in which the flake is molten and produces a consolidated Mn or Mn master alloy ingot is considered critical for subsequent formation of inclusion-free Heusler ingots.

In a Co-Mn-Z alloy system (where Z is an element as defined above), Mn is the main source of oxygen contained in the resultant alloy. This is associated with the raw Mn metal feedstock and is manifested as Mn oxide inclusions. Mn and other transition metals, unlike, for instance, noble metals, tend to form various tenaciously bonded oxides which are virtually impossible to reduce under conventional hydrogen-rich or carbon-rich atmospheres when in solid state condition.

Upon melting of virgin raw materials, since the oxide inclusions are orders of magnitude lighter than the molten metal alloy, the former readily rise and separate into a floating slag. Another important factor for avoiding contamination in the molten state when melting such virgin raw materials is the material of the crucible itself.

Given the high reactivity of molten transition metals, and in order to prevent further oxygen pickup from the crucible, according to the present disclosure, it is essential that the crucible material remain stable vis-à-vis the molten transition metals. The thermodynamic stability is qualitatively assessed based upon the free energy of formation of the metal oxide material of the crucible. As a practical tool, so-called "Ellingham diagrams" are usable for predicting the equilibrium temperature between a metal, its oxide, and oxygen. Referring now to FIG. 6, shown therein is an Ellingham diagram, i.e., a graphical plot of the change in standard free energy of formation (ΔG_{f}) with temperature (°K) for highly stable oxides, including Y₂O₃, CaO, ThO₂, MgO, ZrO₂, and Al₂O₃. It is evident from FIG. 6 that Y₂O₃ is the most stable of the illustrated metal oxides. While Y₂O₃ is in practice an excellent refractory material, the use of Y₂O₃ as a crucible material is economically viable only when small amounts of the latter are admixed with other refractory oxide materials as a reactivity inhibitor or stabilizer, e.g., ZrO₂. Based on the same scale, CaO and MgO are good candidate refractory metal oxide materials for use as crucibles utilized for melting transition metals for achieving low oxygen content.

According to the present disclosure, further reduction of oxygen content in Heusler and Heusler-like alloys is achieved by addition of a minor amount, e.g., about 0.2 to about 0.5 wt. % of deoxidizer (i.e., oxygen gatherer) materials, such as Y, Ca, and Mg, to the melt charge. Ca and/or Mg in granular or shot form are (is) usable for producing Mn and Mn master alloys with significantly reduced oxygen content. In addition to being efficient oxygen gatherers, Ca and Mg exhibit low boiling temperatures and therefore enable excess, un-reacted atoms of the latter elements present after oxygen reduction to be readily evaporated from the melt during melting. Further, Ca acts as an excellent desulfurizer for Mn by promoting decomposition of inclusions of manganese sulfides.

The utility of the present disclosure will now be demonstrated with reference to the following illustrative, but non-limitative examples.

### Example 1

A consolidated Mn ingot was produced by vacuum induction melting (VIM) of 99.9 % pure Mn flake in a magnesium spinel crucible (90 wt. % MgO, 8 wt. % Al₂O₃, 0.9 wt. % CaO, and traces of other oxides) according to the presently disclosed methodology. The Mn flake was melted under 450 mbar partial Ar pressure, and 0.5 wt. % Ca shot was added to the melt, resulting in a consolidated Mn ingot having a low oxygen content of 45 ppm and a residual Ca content of 102 ppm.

### Example 2

A "full" CoMn_{0.25}Al_{0.25} Heusler alloy was prepared by VIM according to the present methodology, i.e., utilizing a metal oxide crucible for preparation of the material to be melted under a partial pressure of an inert gas (e.g., Ar), and then casting the thus-prepared material in a rectangular graphite mold according to the present disclosure, utilizing an apparatus such as shown in FIG. 4 and a post-casting thermal stress relief regime, such as graphically illustrated in FIG. 5.

The melt charge consisted of 6934.4 gms. of 99.5 % pure electrolytic Co, 3232.2 gms. of consolidated Mn ingot prepared as in Example 1, and 1587.4 gms. of 99.9 % pure Al shot. Melting was performed in a magnesia spinel crucible, with an addition of 0.2 wt. % Mg granules. The major residual impurities and gas contents of the resultant product, as measured by wet chemical techniques and Leco analyzers are given below in Table 1, wherefrom it is noted that the concentrations of oxygen and sulfur are extremely low, as is the residual Ca content.

**Table 1**

| Impurities and Gases, ppm | | | | | | | | | |
|---|---|---|---|---|---|---|---|---|---|
| C | N | O | S | Al | Ca | Mg | Fe | Ni | Si |
| 49 | 30 | 3 | N.D. | 13 | 40 | N.D. | N.D. | 87 | 43 |

| | | | | | | | | | |
|---|---|---|---|---|---|---|---|---|---|
| N.D. = Not Detected | | | | | | | | | |

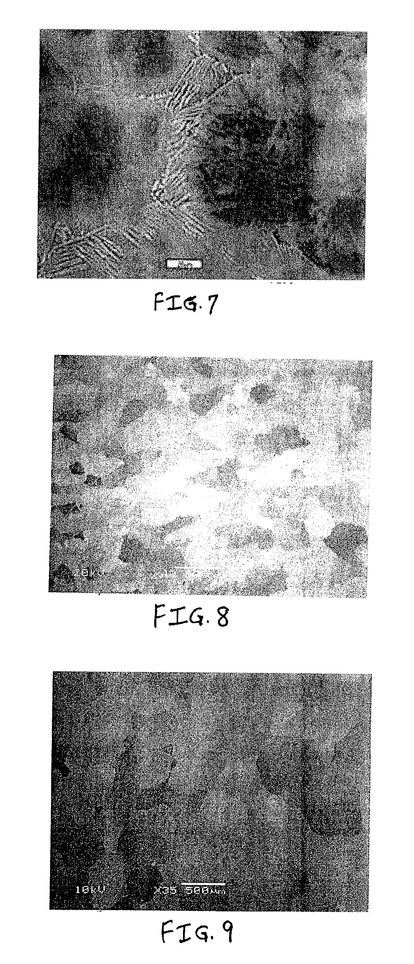

FIG. 7 is a photomicrograph showing the as-cast microstructure of a "full" CoMn_{0.25}Al_{0.25} Heusler alloy prepared as described above, obtained by scanning electron microscopy (SEM) in backscattering mode, examination of which reveals a structure generally comprising single phase Co₂MnAl grains with dimensions up to about 500 µm, the grains being irregularly separated by needle-like CoMn-rich precipitates (the bright phase in FIG. 7).

### Example 3

A "full" CoMn_{0.25}Si_{0.25} Heusler alloy was prepared by VIM according to the present methodology, i.e., utilizing a metal oxide crucible for preparation of the material to be melted under a partial pressure of Ar, and then casting the thus-prepared material in a rectangular graphite mold according to the present disclosure, utilizing an apparatus such as shown in FIG. 4 and a post-casting thermal stress relief regime, such as graphically illustrated in FIG. 5.

The melt charge consisted of 6495 gms. of 99.5 % pure electrolytic Co, 3027.4 gms. of consolidated Mn ingot prepared as in Example 1, and 1547.6 gms. of 99.9 % Si single crystal byproduct pieces. Melting was performed in a magnesia spinel crucible, with an addition of 0.2 wt. % Mg granules. The major residual impurities and gas contents of the resultant product, as measured by wet chemical techniques and Leco analyzers are given below in Table 2, wherefrom it is noted that the concentrations of oxygen and sulfur are extremely low, as is the residual Ca content.

**Table 2**

| Impurities and Gases, ppm | | | | | | | | | |
|---|---|---|---|---|---|---|---|---|---|
| C | N | O | S | Al | Ca | Mg | Fe | Ni | Si |
| 51 | 17 | 13 | N.D. | 11 | 35 | N.D. | 47 | 127 | 22 |

| | | | | | | | | | |
|---|---|---|---|---|---|---|---|---|---|
| N.D. = Not Detected | | | | | | | | | |

FIG. 8 is a photomicrograph showing the as-cast microstructure of a "full" CoMn_{0.25}Si_{0.25} Heusler alloy prepared as described above, obtained by scanning electron microscopy (SEM) in backscattering mode, examination of which reveals a structure generally comprising single phase Co₂MnSi grains with dimensions up to about 800 µm. The large grain size is attributed to slow solidification as a result of casting into a preheated mold.

### Example 4

A pair of master alloys, i.e., a GeCo_{0.45} master alloy and a MnCo_{0.40} master alloy for use as a melt feedstock for forming a CoMnGe Heusler alloy, were prepared according to the presently disclosed methodology, i.e., comprising utilizing vacuum induction melting (VIM), a magnesia spinel crucible, and melting under a 600 mbar Ar partial pressure. Deoxidizing of the molten GeCo_{0.45} master alloy was performed by addition of 0.25 wt. % Mg granules, whereas deoxidizing of the molten MnCo_{0.40} master alloy was performed by addition of 0.40 wt. % Ca shot. The gas contents and Ca and Mg concentrations of the resultant GeCo_{0.45} master alloy and a MnCo_{0.40} master alloy are summarized in Table 3 below.

**Table 3**

| Residual Deoxidizer Concentrations and Resultant Gas Contents, ppm | | | | | | |
|---|---|---|---|---|---|---|
| | C | N | O | S | Ca | Mg |
| GeCo_{0.45} master alloy | 37 | 9 | 1 | 15 | / | 19 |
| MnCo_{0.40} master alloy | 43 | 14 | 10 | 2 | 13 | / |

### Example 5

A "full" CoMn_{0.25}Ge_{0.25} Heusler alloy was prepared by VIM according to the present methodology, i.e., utilizing a metal oxide crucible for preparation of the material to be melted under a partial pressure of Ar, and then casting the thus-prepared material in a rectangular graphite mold according to the present disclosure, utilizing an apparatus such as shown in FIG. 4 and a post-casting thermal stress relief regime, such as graphically illustrated in FIG. 5.

The melt charge consisted of 1594.3 gms. of 99.5 % pure electrolytic Co, 6345.3 gms. of the consolidated GeCo_{0.45} master alloy made in Example 4 and 4948.4 gms. of the consolidated MnCo_{0.40} master alloy made in Example 4. Melting was performed in a magnesia spinel crucible under a 500 mbar Ar partial pressure, with an addition of 0.2 wt. % Mg granules. The major residual impurities and gas contents of the resultant product, as measured by wet chemical techniques and Leco analyzers are given below in Table 4, wherefrom it is noted that the concentrations of oxygen and sulfur are extremely low, as are the residual Ca and Mg contents.

FIG. 9 is a photomicrograph showing the as-cast microstructure of a "full" CoMn_{0.25}Ge_{0.25} Heusler alloy prepared as described above, obtained by scanning electron microscopy (SEM) in backscattering mode, examination of which reveals a structure generally comprising single phase Co₂MnGe grains with dimensions up to about 800 µm. The large grain size is attributed to slow solidification as a result of casting into a preheated mold.

**Table 4**

| Impurities and Gases, ppm | | | | | | | | | |
|---|---|---|---|---|---|---|---|---|---|
| C | N | O | S | Al | Ca | Mg | Fe | Ni | Si |
| 51 | 7 | N.D. | N.D. | 27 | 10 | 13 | N.D. | 111 | 24 |

| | | | | | | | | | |
|---|---|---|---|---|---|---|---|---|---|
| N.D. = Not Detected | | | | | | | | | |

The methodology of the present disclosure is capable of producing crack, free, mechanically sound ingots which are ready for further processing, e.g., cutting and grinding into deposition sources, such as a sputtering targets. Given the brittle character of Heusler and Heusler-like alloys, cutting is preferably performed by electro-discharge machining (EDM) and final sizing to target dimensions (e.g., thickness) is accomplished by gentle grinding. Whereas manufacture of a monolithic Heusler or Heusler-like alloy target is possible, most targets are manufactured as an assembly comprising a target bonded to a metallic backing plate in order to maintain integrity and lifetime of the sputtering targets.

In summary, the methodologies afforded by the present disclosure advantageously facilitate efficient, cost-effective manufacture of a wide variety of crack-free, low oxygen (and sulfur) content Heusler and Heusler-like alloy materials well-suited for fabrication into deposition sources, notably sputtering targets, useful in the manufacture of a number of advanced technology, thin film-based products and devices requiring very low oxygen content Heusler or Heusler-like alloy layers, including, for example, electronic spin-based magnetic heads/devices, magneto-resistance tunnel (TMR) junction devices, and giant magneto-resistance (GMR) spin heads/sensor devices.

In the previous description, numerous specific details are set forth, such as specific materials, structures, processes, etc., in order to provide a better understanding of the present disclosure. However, the present disclosure can be practiced without resorting to the details specifically set forth herein. In other instances, well-known processing techniques, structures, and methodologies have not been described herein in order not to unnecessarily obscure the present disclosure.

Only the preferred embodiments of the present disclosure and but a few examples of its versatility are shown and described herein. It is to be understood that the present disclosure is capable of use in various other combinations and environments and is susceptible of changes and/or modifications within the scope of the inventive concept as expressed herein.

## Claims

1. A method of forming a Heusler or Heusler-like alloy of formula X₂YZ or XYZ, comprising steps of:
(a) providing a crucible comprised of at least one metal oxide material thermodynamically stable to molten transition metals;
(b) supplying predetermined amounts of constituent elements or master alloy materials of said Heusler or Heusler-like alloy to said crucible; and
(c) melting said constituent elements or master alloy materials under vacuum or a partial pressure of an inert gas to form a Heusler or Heusler-like alloy containing less than about 50 ppm oxygen.

2. The method according to claim 1, wherein:
step (a) comprises providing a crucible comprised of at least one metal oxide material selected from the group consisting of: Y₂O₃, CaO, ThO₂, MgO, ZrO₂, and Al₂O₃.

3. The method according to claim 1, wherein:
step (b) comprises supplying predetermined amounts of different constituent transition metal elements X and Y, each selected from the group consisting of Sc, Ti, V, Cr, Mn, Fe, Co, Ni, Y, Zr, Nb, Mo, Ru, Rh, Lu, Hf, Ta, W, Re, Ir, and Pt; and supplying predetermined amounts of at least one constituent element Z, selected from the group consisting of: Al, Si, Ga, Ge, As, In, Sn, Sb, Te, Tl, Pb, and Bi.

4. The method according to claim 1, wherein:
step (b) comprises supplying a predetermined amount of a first master alloy of formula XY, comprising different transition metal elements X and Y each selected from the group consisting of Sc, Ti, V, Cr, Mn, Fe, Co, Ni, Y, Zr, Nb, Mo, Ru, Rh, Lu, Hf, Ta, W, Re, Ir, and Pt; and a predetermined amount of a second master alloy of formula XZ, comprising a transition metal element X selected from the group consisting of Sc, Ti, V, Cr, Mn, Fe, Co, Ni, Y, Zr, Nb, Mo, Ru, Rh, Lu, Hf, Ta, W, Re, Ir, and Pt and an element Z selected from the group consisting of: Al, Si, Ga, Ge, As, In, Sn, Sb, Te, Tl, Pb, and Bi.

5. The method according to claim 1, wherein:
step (b) comprises supplying at least one deoxidizer material to said crucible.

6. The method according to claim 5, wherein:
step (b) comprises supplying to said crucible at least one deoxidizer material selected from the group consisting of: Y, Ca, and Mg.

7. The method according to claim 1, further comprising a step of:
(d) melting and casting said Heusler or Heusler-like alloy formed in step (c) in a mold to form an as-cast ingot and subjecting the as-cast ingot to a stress-relieving, heat-assisted casting process to form a crack-free ingot.

8. The method according to claim 7, wherein:
step (d) comprises subjecting the as-cast ingot to a multi-stage post-casting thermal profile to form said crack-free ingot.

9. The method according to claim 8, wherein step (d) comprises performing:
(1) a mold pre-heat first stage during which the temperature of the casting mold is increased to and maintained at a predetermined elevated temperature;
(2) a casting and cool-down second stage initiated upon pouring of the molten Heusler or Heusler-like alloy material into the pre-heated mold to form said as-cast ingot;
(3) a mold and ingot temperature hold during stress relief third stage for performing continuous stress relief at temperatures where Heusler and Heusler-like alloy materials are most susceptible to crack initiation; and
(4) a final controlled cool-down fourth stage during which a slow cool-down rate is imposed on the ingot in order to prevent build-up of thermal gradients and subsequent crack development.

10. A method comprising steps of:
(a) providing a molten Heusler or Heusler-like alloy of formula X₂YZ or XYZ; and
(b) casting said molten Heusler or Heusler-like alloy in a mold utilizing a stress-relieving, heat-assisted casting process to form a crack-free, cast ingot.

11. The method according to claim 10, wherein step (a) comprises providing a molten Heusler or Heusler-like alloy containing less than about 50 ppm oxygen.

12. The method according to claim 11, wherein:
step (a) comprises providing a molten Heusler or Heusler-like alloy wherein X and Y are different transition metal elements each selected from the group consisting of Sc, Ti, V, Cr, Mn, Fe, Co, Ni, Y, Zr, Nb, Mo, Ru, Rh, Lu, Hf, Ta, W, Re, Ir, and Pt; and Z is at least one element selected from the group consisting of: Al, Si, Ga, Ge, As, In, Sn, Sb, Te, Tl, Pb, and Bi.

13. The method according to claim 11, further comprising a step of:
(c) forming a deposition source from said crack-free, cast ingot.

14. The method according to claim 13, wherein:
step (c) comprises forming a sputtering target including a backing plate.

15. The method according to claim 10, wherein step (b) comprises performing:
(1) a mold pre-heat first stage during which the temperature of the casting mold is increased to and maintained at a predetermined elevated temperature;
(2) a casting and cool-down second stage initiated upon pouring of the molten Heusler or Heusler-like alloy material into the pre-heated mold to form an as-cast ingot;
(3) a mold and ingot temperature hold during stress relief third stage for performing continuous stress relief at temperatures where Heusler alloy materials are most susceptible to crack initiation; and
(4) a final controlled cool-down fourth stage during which a slow cool-down rate is imposed on the ingot in order to prevent build-up of thermal gradients and subsequent crack development.

16. A crack-free Heusler or Heusler-like alloy of X₂YZ or XYZ formula containing less than about 50 ppm oxygen.

17. The alloy as in claim 16, wherein:
X and Y each are different transition metal elements selected from the group consisting of Sc, Ti, V, Cr, Mn, Fe, Co, Ni, Y, Zr, Nb, Mo, Ru, Rh, Lu, Hf, Ta, W, Re, Ir, and Pt; and Z is at least one element selected from the group consisting of: Al, Si, Ga, Ge, As, In, Sn, Sb, Te, Tl, Pb, and Bi.

18. The alloy as in claim 16, of X₂YZ formula, wherein X is Co, Y is Mn, and Z is Al, Si, or Ge.

19. A deposition source comprising a crack-free Heusler or Heusler-like alloy of X₂YZ or XYZ formula containing less than about 50 ppm oxygen.

20. The deposition source as in claim 19, wherein:
X and Y each are different transition metal elements selected from the group consisting of Sc, Ti, V, Cr, Mn, Fe, Co, Ni, Y, Zr, Nb, Mo, Ru, Rh, Lu, Hf, Ta, W, Re, Ir, and Pt; and Z is at least one element selected from the group consisting of: Al, Si, Ga, Ge, As, In, Sn, Sb, Te, Tl, Pb, and Bi.

21. The deposition source as in claim 19, of X₂YZ formula, wherein X is Co, Y is Mn, and Z is Al, Si, or Ge.

22. The deposition source as in claim 19, in the form of a sputtering target.

23. The sputtering target as in claim 22, comprising a backing plate.
